# EUROPEAN PATENT SPECIFICATION

(11) **EP 2 786 592 B1**
(45) Date of publication and mention of the grant of the patent: **22.03.2017**
(21) Application number: 12821118.2
(22) Date of filing: 28.11.2012
(51) Int. Cl.: H04R 1/06, H04R 11/02, H01R 12/71, H04R 25/00, H04R 31/00, H05K 3/30

(54) **ELECTRO-ACOUSTIC TRANSDUCER FOR MOUNTING ON A SUBSTRATE**
ELEKTROAKUSTISCHER WANDLER ZUR MONTAGE AUF EINEM SUBSTRAT
TRANSDUCTEUR ÉLECTRO-ACOUSTIQUE POUR MONTAGE SUR UN SUBSTRAT

(30) Priority: 02.12.2011 GB 201120741
(43) Date of publication of application: 08.10.2014
(73) Proprietor: Soundchip SA, 1030 Bussigny-Pres-Lausanne (CH)
(72) Inventor: DARLINGTON, Paul, 1030 Bussigny-pres-Lausanne (CH); DONALDSON, Mark, 1030 Bussigny-pres-Lausanne (CH)
(74) Representative: Abraham, Richard
(86) International application number: PCT/GB2012/052929
(87) International publication number: WO 2013/079930

(56) References cited:
- EP-A2- 1 122 979
- EP-A2- 1 653 767
- WO-A1-00/74437
- WO-A1-2005/069681
- GB-A- 2 306 806
- US-A- 4 420 706
- US-A1- 2006 116 180
- US-A1- 2006 237 806
- US-A1- 2007 026 905
- US-A1- 2009 274 334
- US-A1- 2010 128 914

## Description

The present invention relates to an electro-acoustic driver, and particularly but not exclusively to a Balanced Armature (BA) driver.

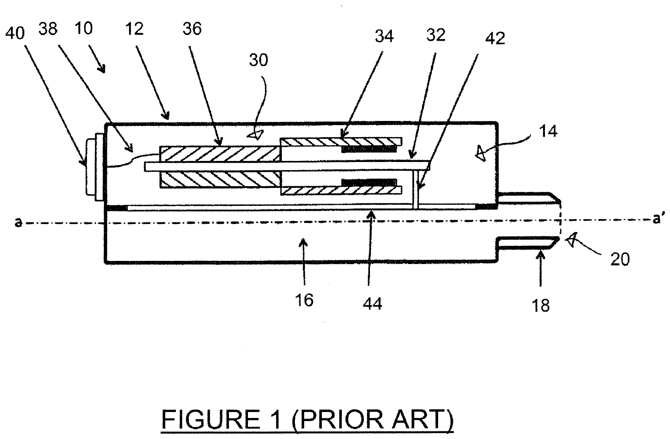

Figure 1 shows an example of a conventional Balanced Armature (BA) driver 10 of the type used extensively in hearing aid applications and in-ear devices for communication and entertainment. Inheriting the nomenclature of telecommunications, this form of driver is conventionally called a receiver.

BA driver 10 comprises an elongate casing 12 extending along axis aa', the elongation of the casing having been encouraged during the development of BA receivers in the context of applications in hearing aids where the drive for miniaturisation in "Behind the Ear" and "In the Ear" devices has created demand for receivers having minimum area normal to longitudinal axis aa' such that the receiver fits in a narrow enclosure or is able to sit behind the outer ear or even within the confines of the ear canal itself.

Casing 12 defines a motor chamber 14 housing electro-dynamic motor mechanism 30 and an impedance matching compression chamber 16 leading to a spout 18, convenient for connection to tubing, extending along axis aa' and defining an opening 20 for sound to exit casing 12. The driver chamber 14 and the compression chamber 16 are partitioned by an elastically suspended diaphragm 44 forming part of motor mechanism 30.

Motor mechanism 30 comprises an armature 32 which gives the device its name, the armature 32 being held within a magnetic circuit formed by a magnet assembly 34. A coil 36 extending around one end of armature 32 passes current (e.g. from an amplifier) applied through electrical connection 38 and external electrical terminals 40. The combination of the magnetic field and applied current gives rise to a force acting to displace armature 32 from its mechanical equilibrium.

Armature 32 is mechanically coupled through a rod 42 to diaphragm 44 causing pressure change in the volume of air contained in compression chamber 16. Spout 18 guides sound waves generated in compression chamber to opening 20.

The present applicant has identified the need for an improved form of BA driver offering improved connectivity with other components in an audio device and the potential for more efficient manufacture and more flexible system design.

US 2006/237806 A1 shows an electro-acoustic microphone transducer for the use on a substrate. A similar example is known from US 2010/128914 A1, which shows a microphone transducer mounted on a substrate having an acoustic waveguide.

A balanced armature transducer for mounting on a substrate is known from EP 1 653 767 A2. Said transducer shows venting holes additional to the main sound outlet.

In accordance with a first aspect of the present invention, there is provided apparatus comprising: a substrate defining an interior acoustic waveguide, and an electro-acoustic driver mounted on the substrate, the electro-acoustic driver comprising: a body defining a mounting surface for mounting the electro-acoustic driver on the substrate (e.g. printed circuit board or equivalent substrate) defining an interior acoustic waveguide; and an opening for allowing sound intended for the interior acoustic waveguide to exit the body; a diaphragm mounted in the body; and a compression chamber located between the diaphragm and the opening; wherein the opening is located on the mounting surface.

In this way, an electro-acoustic driver (e.g. Balanced Armature driver)/substrate combination is provided in which each of a mechanical, electrical and acoustical interface to the mounting substrate may be achieved through a common plane (e.g. a mounting surface facing the substrate).

In one embodiment the mounting surface defines at least one electrical connection path.

In one embodiment the opening substantially faces the diaphragm. For example, the opening may be at least partially or substantially aligned with a part of the diaphragm.

In one embodiment the opening defines a passageway extending from the compression chamber to a region outside of the body, the passageway having a longitudinal length that is less than or substantially equal to its smallest width (e.g. smallest mean dimension in any direction orthogonal to its length). In one embodiment, the passageway extends from a first side of a casing wall of the body defining the mounting surface to a second side of the casing wall facing the compression chamber (e.g. opposed to the first side of the casing wall). Advantageously, the provision of such a short passageway may provide a simpler acoustic behaviour than a spout arrangement of the type used in conventional BA receivers, thereby allowing the system designer greater flexibility in modifying the frequency response of the system by changing the radiating conditions close to the driver (e.g. by altering the acoustic behaviour of the interior acoustic waveguide formed in the substrate to which the transducer is mounted and acoustically connected). Such modifications may be desirable in shaping the frequency response of the system for improved audio quality or for the deliberate manipulation of a factor of the "system under control" (e.g. in an active noise reduction system).

In one embodiment the body is an elongate body defining a longitudinal axis. In one embodiment, the passageway extends substantially normal to the longitudinal axis of the body.

In one embodiment the diaphragm is part of an electro-dynamic transducer.

In another embodiment the diaphragm is part of an electrostatic transducer (e.g. piezoelectric transducer).

In one embodiment the diaphragm is part of a balanced armature transducer.

In one embodiment the mounting surface defines at least one solderable region for forming a connection (e.g. electrical, mechanical or acoustic connection) with the substrate (e.g. when the electro-acoustic driver is mounted on the substrate during a flow-soldering process or other "surface mount" process). In one embodiment the solderable region comprises a solderable pad (e.g. for providing electrical connection between the electro-acoustic driver and the substrate). In another embodiment the solderable region comprises a solderable sealing part (e.g. solderable band or ring) enclosing the opening (e.g. for forming an airtight acoustic seal between the electro-acoustic driver and the interior acoustic waveguide formed in the substrate).

In accordance with a second aspect of the present invention, there is provided an electro-acoustic transducer as defined in appendant independent claim 9 to which reference should now be made. Embodiments of the second aspect of the invention are defined in the appendant dependant claims 10-13 to which reference should also now be made.

The scope of the present invention is defined by the appendant claims.

Embodiments of the present invention will now be described by way of example with reference to the accompanying drawings in which:
Figure 1 is a schematic cross-sectional view of a prior art BA transducer;
Figure 2 is a schematic cross-sectional view of an electro-acoustic transducer in accordance with an embodiment of the present invention;
Figure 3 is a schematic cross-sectional view of the electro-acoustic transducer of Figure 2 mounted on a substrate;
Figure 4 is a schematic cross-sectional view of a first mounting apparatus with the BA transducer of Figure 1 mounted thereon; and
Figure 5 is a schematic cross-sectional view of a second mounting apparatus with the BA transducer of Figure 1 mounted thereon.

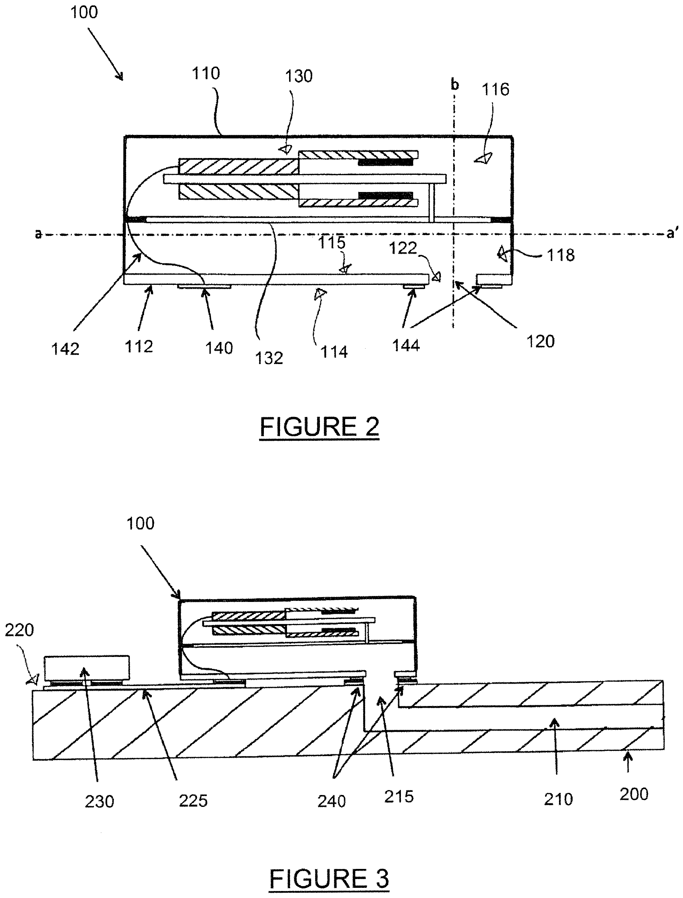

Figure 2 shows Balanced Armature (BA) driver 100 comprising an elongate casing 110 defining a longitudinal axis aa'. Casing 110 including a planar base 112 formed using manufacturing processes, material and technologies associated with electronic packaging and defining a mounting surface 114 for mounting BA driver 100 on a substrate (e.g. printed circuit board or equivalent substrate). Casing 110 further defines a motor chamber 116 housing a Balanced Armature motor mechanism 130 of the type depicted in Figure 1 and an impedance matching compression chamber 118 leading to a circular opening 120. As in the device of Figure 1, motor chamber 116 and compression chamber 118 are partitioned by a diaphragm 132 forming part of motor mechanism 130.

Opening 120 defines a passageway 122 extending through base 112 along axis bb' from mounting surface 114 to an inner surface 115 of base 112 opposed to the mounting surface 114 defining a lower boundary of compression chamber 118. Passageway 122 has a longitudinal length equal to the thickness of base 112 which is less than the diameter of the opening. Whilst passageway 122 may have a comparable width to a conventional spout of a BA driver of the type depicted in Figure 1, passageway 122 is significantly shorter than such a spout and closer to the acoustic centre of the driver thereby offering a simpler acoustic behaviour.

Base 112 includes one or more solderable pads (e.g. metal pads) 140 for providing electrical connection to motor mechanism 130 to allow operating currents to pass via internal conductors 142 to the coil of motor mechanism 130. Base 112 additionally includes a solderable ring 144 (e.g. metal ring) enclosing opening 120 to provide a mechanical connection and airtight seal around opening 120 when the electro-acoustic transducer is mounted on a suitable substrate. Solderable pad(s) 140 and ring 144 are configured to be soldered to the substrate during a flow-soldering process or other "surface mount" process). Alternatively solderable ring 144 may be replaced with a band or ring of compliant material having on its outer surface an adhesive region configured to bond the electro-acoustic transducer to the substrate to form an equivalent airtight seal around the opening.

Figure 3 shows BA driver 100 mounted on a substrate 200 developed by the present applicant (and as described in the applicant's co-pending applications GB 1103824.7 and GB 1120370.0), the substrate 200 defining an interior acoustic waveguide 210 and connecting passageway 215 for conveying sound through the substrate from BA driver 100 to a point exterior to the substrate 200.

Substrate 200 includes an upper surface 220 defining solderable electrical connection pads and connecting conductor tracks (e.g. metal conductor regions) 225 for making electrical connection between solderable pad(s) 140 on BA driver 100 and other electronic components 230 mounted on substrate 200. Substrate 200 also includes a solderable ring (e.g. metal ring) 240 registrable with solderable ring 144 on BA driver 100 to form the solder seal connection between opening 120 and connecting passageway 215.

The design of BA driver 100 with its substantially acoustically inert opening 120 is such that substrate 200 may substantially define the acoustic loading conditions for the BA driver 100 through the design of connecting passageway 215 and/or acoustic waveguide 210, the design of which will strongly influence electro-acoustic performance of the overall system. In this way, a single BA driver design may be used in a range of applications in which the acoustic response is tailored by the acoustic design of the application rather than dictated by the driver.

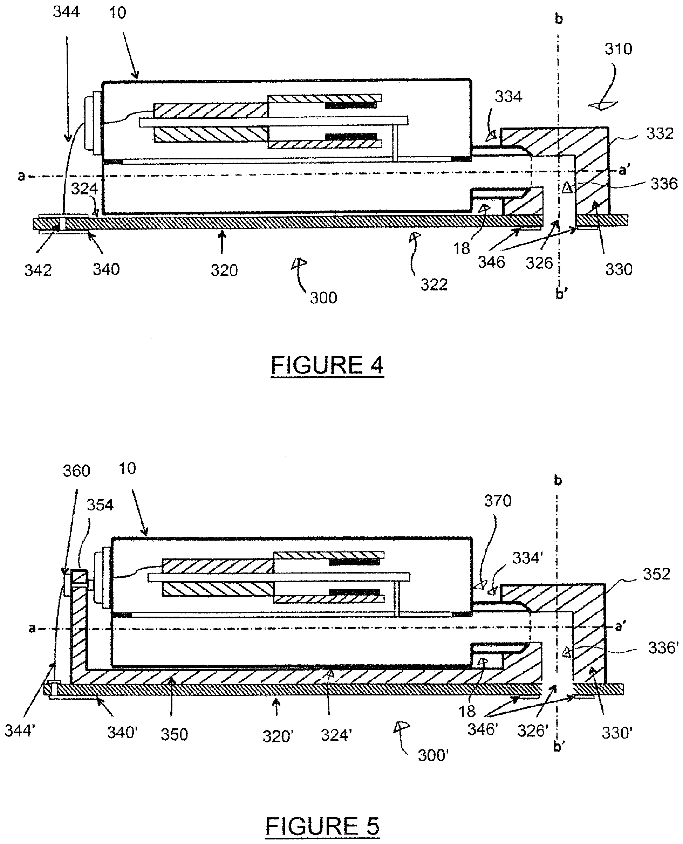

Many of the manufacturing advantages associates with the mounting of BA driver 100 via a shared mechanical, electrical and acoustical interface can be extended to a conventional driver by using the mounting apparatus of Figures 4 and 5.

Figure 4 shows mounting apparatus 300 for mounting conventional BA driver 10 of Figure 1 on a substrate (e.g. printed circuit board or equivalent substrate). Mounting apparatus comprises a carrier structure 310 comprising a substantially planar base 320 and acoustic connector 330. Base 320 defines a substrate mounting surface 322 for mounting the carrier structure on a substrate (not shown) and a transducer mounting surface 324 opposed to substrate mounting surface 322 for receiving BA driver 10. Acoustic connector 330 comprises a body 332 defining a port 334 for receiving a leading end of spout 18 and an acoustic waveguide 336 for connecting port 334 to an opening 326 laterally spaced from the transducer mounting surface 324 extending through base 320 (and analogous to opening 120) for conveying sound to the substrate, and thereby directing sound from the spout propagating along axis aa' to the normal axis bb'.

Base 320 includes one or more solderable pads (e.g. metal pads) 340 for providing electrical connection to BA driver 10. The solderable pad(s) 340 communicate via conducting paths (or "vias") 342 to transducer mounting surface 324 allowing electrical connection to BA driver 10 through conductors 344. Base 320 also includes a solderable ring 346 (e.g. metal ring) enclosing opening 326 to provide a mechanical connection and airtight seal around opening 326 when mounting apparatus 300 is mounted on a suitable substrate (although other means may be used to provide this seal, as previously discussed). As before, solderable pad(s) 140 and ring 144 are configured to be soldered to the substrate during a flow-soldering process or other "surface mount" process.

Figure 5 shows an alternative mounting apparatus 300' based on mounting apparatus 300 (with corresponding features labelled accordingly) and further comprising a chassis 350 including a first wall part 352 including acoustic connector 330' and a second wall part 354 defining electrical connectors 360 for receiving electrical signals via conductors 344'. Together first wall part 352 and second wall part 354 define a compartment 370 for receiving BA driver 10. The first and second wall parts 352, 354 may be formed as a single component as illustrated or may comprise a plurality of discrete parts for performing the functions described.

In use, a leading end of spout 18 is first inserted into connecting port 334' of acoustic connector 330' and then a trailing end of casing 12 is pushed into compartment 370. Optionally, electrical connectors 360 may be sprung members allowing the connectors to serve additionally as locating means for BA driver 10.

It is intended that mounting apparatus 300' is mounted on a substrate (e.g. printed circuit board or equivalent substrate) during system assembly. However, BA driver 10 may be mounted in carrier structure 310' at a later stage in assembly. This is advantageous in cases where the driver is not capable of surviving stress of a part of the manufacturing process (e.g. thermal stress associated with flow soldering and associated surface mount techniques).

## Claims

1. Apparatus comprising:
a substrate (200) defining an interior acoustic waveguide (210); and
an electro-acoustic driver (100) mounted on the substrate, the electro-acoustic driver (100) comprising:
a body (110) defining: a mounting surface (114) for mounting the electro-acoustic driver (100) on the substrate (200); and an opening (120) for allowing sound intended for the interior acoustic waveguide (210) to exit the body (110);
a diaphragm (132) mounted in the body (110); and
a compression chamber (118) located between the diaphragm (132) and the opening (120);
wherein the opening (120) is located on the mounting surface (114).

2. Apparatus according to claim 1, wherein the opening (120) defines a passageway (122) extending from the compression chamber (118) to a region outside of the body (110), the passageway (122) having a longitudinal length that is less than or substantially equal to its smallest width.

3. Apparatus according to claim 1 or claim 2, wherein the diaphragm (132) is part of an electro-dynamic transducer.

4. Apparatus according to claim 1 or claim 2, wherein the diaphragm (132) is part of an electrostatic transducer.

5. Apparatus according to any of the preceding claims, wherein the diaphragm (132) is part of a balanced armature transducer.

6. Apparatus according to any of the preceding claims, wherein the mounting surface (114) defines at least one solderable region for forming a connection with the substrate (200).

7. Apparatus according to claim 6, wherein the solderable region comprises a solderable pad (140).

8. Apparatus according to claim 6, wherein the solderable region comprises a solderable sealing part (144) enclosing the opening (120).

9. An electro-acoustic transducer (100) comprising:
a body (110) defining a mounting surface (114) for mounting the electro-acoustic transducer (100) on a substrate (200) and an opening (120) for allowing sound to enter or exit the body (100);
a diaphragm (132) mounted in the body (110); and
a compression chamber (118) located between the diaphragm (132) and the opening (120);
wherein the diaphragm (132) is part of a balanced armature transducer and the opening (120) is located on the mounting surface (114).

10. An electro-acoustic transducer (100) according to claim 9, wherein the opening (120) defines a passageway (122) extending from the compression chamber (118) to a region outside of the body (110), the passageway (122) having a longitudinal length that is less than or substantially equal to its smallest width.

11. An electro-acoustic transducer (100) according to claim 9 or claim 10, wherein the mounting surface (114) defines at least one solderable region for forming a connection with a substrate.

12. An electro-acoustic transducer (100) according to claim 11, wherein the solderable region comprises a solderable pad (140).

13. An electro-acoustic transducer (100) according to claim 11, wherein the solderable region comprises a solderable sealing part (144) enclosing the opening.

## Patentansprüche

1. Vorrichtung, die Folgendes umfasst:
ein Substrat (200), das einen internen akustischen Wellenleiter (210) definiert; und
einen auf dem Substrat montierten elektroakustischen Treiber (100), wobei der elektroakustische Treiber (100) Folgendes umfasst:
ein Gehäuse (110), das Folgendes definiert: eine Montagefläche (114) zum Montieren des elektroakustischen Treibers (100) auf dem Substrat (200); und eine Öffnung (120), um es zuzulassen, dass für den internen akustischen Wellenleiter (210) beabsichtigter Schall das Gehäuse (110) verlässt;
eine in dem Gehäuse (110) montierte Membran (132); und
eine Kompressionskammer (118), die sich zwischen der Membran (132) und der Öffnung (120) befindet;
wobei sich die Öffnung (120) auf der Montagefläche (114) befindet.

2. Vorrichtung nach Anspruch 1, wobei die Öffnung (120) einen Durchgang (122) definiert, der von der Kompressionskammer (118) zu einer Region außerhalb des Gehäuses (110) verläuft, wobei der Durchgang (122) eine longitudinale Länge hat, die im Wesentlichen gleich oder geringer als ihre geringste Breite ist.

3. Vorrichtung nach Anspruch 1 oder Anspruch 2, wobei die Membran (132) Teil eines elektrodynamischen Wandlers ist.

4. Vorrichtung nach Anspruch 1 oder Anspruch 2, wobei die Membran (132) Teil eines elektrostatischen Wandlers ist.

5. Vorrichtung nach einem der vorherigen Ansprüche, wobei die Membran (132) Teil eines Balanced-Armature-Wandlers ist.

6. Vorrichtung nach einem der vorherigen Ansprüche, wobei die Montagefläche (114) wenigstens eine lötbare Region zum Bilden einer Verbindung mit dem Substrat (200) definiert.

7. Vorrichtung nach Anspruch 6, wobei die lötbare Region ein lötbares Pad (140) umfasst.

8. Vorrichtung nach Anspruch 6, wobei die lötbare Region einen lötbaren Dichtungsteil (144) umfasst, der die Öffnung (120) umschließt.

9. Elektroakustischer Wandler (100), der Folgendes umfasst:
ein Gehäuse (110), das eine Montagefläche (114) zum Montieren des elektroakustischen Wandlers (100) auf einem Substrat (200) und eine Öffnung (120) definiert, um es zuzulassen, dass Schall in das Gehäuse (100) eintritt oder es verlässt;
eine in dem Gehäuse (110) montierte Membran (132); und
eine Kompressionskammer (118), die sich zwischen der Membran (132) und der Öffnung (120) befindet;
wobei die Membran (132) Teil eines Balanced-Armature-Wandlers ist und die Öffnung (120) sich auf der Montagefläche (114) befindet.

10. Elektroakustischer Wandler (100) nach Anspruch 9, wobei die Öffnung (120) einen Durchgang (122) definiert, der von der Kompressionskammer (118) zu einer Region außerhalb des Gehäuses (110) verläuft, wobei der Durchgang (122) eine longitudinale Länge hat, die im Wesentlichen gleich oder geringer ist als ihre geringste Breite.

11. Elektroakustischer Wandler (100) nach Anspruch 9 oder Anspruch 10, wobei die Montagefläche (114) wenigstens eine lötbare Region zum Bilden einer Verbindung mit einem Substrat definiert.

12. Elektroakustischer Wandler (100) nach Anspruch 11, wobei die lötbare Region einen lötbares Pad (140) umfasst.

13. Elektroakustischer Wandler (100) nach Anspruch 11, wobei die lötbare Region einen lötbaren Dichtungsteil (144) umfasst, der die Öffnung umschließt.

## Revendications

1. Appareil comprenant :
un substrat (200) définissant un guide d'onde acoustique intérieur (210) ; et
un circuit d'attaque électro-acoustique (100) monté sur le substrat, le circuit d'attaque électro-acoustique (100) comprenant :
un corps (110) définissant : une surface de montage (114) pour monter le circuit d'attaque électro-acoustique (100) sur le substrat (200) ; et une ouverture (120) pour permettre au son destiné au guide d'onde acoustique intérieur (210) de sortir du corps (110) ;
un diaphragme (132) monté dans le corps (110) ; et
une chambre de compression (118) localisée entre le diaphragme (132) et l'ouverture (120) ;
cas dans lequel l'ouverture (120) est localisée sur la surface de montage (114).

2. Appareil selon la revendication 1, l'ouverture (120) définissant un passage (122) qui s'étend depuis la chambre de compression (118) jusqu'à une région à l'extérieur du corps (110), le passage (122) ayant une longueur longitudinale qui est inférieure ou sensiblement égale à sa largeur la plus petite.

3. Appareil selon la revendication 1 ou la revendication 2, le diaphragme (132) faisant partie d'un transducteur électro-dynamique.

4. Appareil selon la revendication 1 ou la revendication 2, le diaphragme (132) faisant partie d'un transducteur électro-statique.

5. Appareil selon l'une quelconque des revendications précédentes, le diaphragme (132) faisant partie d'un transducteur à palette équilibrée.

6. Appareil selon l'une quelconque des revendications précédentes, la surface de montage (114) définissant au moins une région brasable pour former une connexion avec le substrat (200).

7. Appareil selon la revendication 6, la région brasable comprenant un patin brasable (140).

8. Appareil selon la revendication 6, la région brasable comprenant une partie d'étanchéisation brasable (144) qui renferme l'ouverture (120).

9. Transducteur électro-acoustique (100) comprenant :
un corps (110) définissant une surface de montage (114) pour monter le transducteur électro-acoustique (100) sur un substrat (200) et une ouverture (120) pour permettre au son d'entrer dans le corps (100) ou d'en sortir ;
un diaphragme (132) monté dans le corps (110) ; et
une chambre de compression (118) localisée entre le diaphragme (132) et l'ouverture (120) ;
cas dans lequel le diaphragme (132) fait partie d'un transducteur à palette équilibrée et l'ouverture (120) est localisée sur la surface de montage (114).

10. Transducteur électro-acoustique (100) selon la revendication 9, l'ouverture (120) définissant un passage (122) qui s'étend depuis la chambre de compression (118) jusqu'à une région à l'extérieur du corps (110), le passage (122) ayant une longueur longitudinale qui est inférieure ou sensiblement égale à sa largeur la plus petite.

11. Transducteur électro-acoustique (100) selon la revendication 9 ou la revendication 10, la surface de montage (114) définissant au moins une région brasable pour former une connexion avec un substrat.

12. Transducteur électro-acoustique (100) selon la revendication 11, la région brasable comprenant un patin brasable (140).

13. Transducteur électro-acoustique (100) selon la revendication 11, la région brasable comprenant une partie d'étanchéisation brasable (144) qui renferme l'ouverture.
